# EUROPEAN PATENT APPLICATION

(11) **EP 1 887 099 A1**
(43) Date of publication of application: **13.02.2008**
(21) Application number: 06254248.5
(22) Date of filing: 12.08.2006
(51) Int. Cl.: C23C 14/34

(54) **Method for manufacturing diamond-like carbon film**

(71) Applicant: Tatung Company, Jhongshan District Taipei City 104 (TW)
(72) Inventor: Lo, Jason, Taipei City 104 (TW); Jeng, Jian-Min, Taipei City 104 (TW)
(74) Representative: Tranter, Andrew David

(57) **Abstract**

A method for manufacturing diamond-like carbon (DLC) film is disclosed. The method mainly includes steps of: (a) fixing a substrate in a reaction chamber; (b) pumping the pressure of the reaction chamber below 10⁻⁶ torr; (c) introducing at least a carbon-containing gas into the reaction chamber; and (d) depositing a diamond-like carbon film on the substrate by sputtering a graphite target. The deposited DLC film is in a shape of flakes. The appearance of the deposited DLC film on the surface of the substrate is in a rose-like shape. Moreover, the height of the deposited DLC film is of micrometer level, and the thickness of the deposited DLC film is of nanometer level. Since the aspect ratio of the deposited flake-shaped DLC film is high, the deposited DLC film can enhance the field emission.

## Description

### BACKGROUND OF THE INVENTION

### 1. Field of the Invention

The present invention relates to a method for manufacturing a diamond-like carbon (film) film and, more particularly, to a method for manufacturing a diamond-like carbon (film) film by sputtering and growing the film on the surface of a substrate.

### 2. Description of Related Art

The current research in field emission display mainly focuses on carbon materials because of the short lifetime and difficulties in preparation of metal tips electron emission components known in the art. Therefore, carbon materials having chemical stability, conductivity, or low electron affinity are commonly utilized nowadays as the targets of R&D. The related carbon materials include amorphous carbon film, diamond film, diamond-like carbon film, and carbon nanotube.

Due to their high aspect ratio, carbon nanotubes have low turn-on voltage and high emission current density, that is, good field emission enhancing factor, making them popular field emission electronic materials at present. However, when carbon nanotubes are subjected to the subsequent process and application, they are difficult to be dispersed uniformly in the desired paste, leading to uneven distribution of current and shortened lifetime. Thus, carbon nanotubes must undergo surface ' modification to increase stability in field emission.

Diamond-like carbon is composed essentially of non-crystal carbon having SP³ 3-D and SP² planar structure. SP³ has low electron affinity and superior mechanical properties, and SP² has good conductive properties, so the diamond-like materials formed of the above two kinds of structures have both low electron affinity and good conductive properties.

Though diamond-like carbons have the advantage of low electron affinity, electron-emission abilities of prior art diamond carbons are still slightly lower than those of carbon nanotubes. This is because the diamond-like carbon structures known in the art do not have as a high aspect ratio as carbon nanotubes do. A diamond-like carbon film is disclosed in Taiwan Patent No.00444232, but its structure is formed by forming a diamond-like carbon film on a tip used for electron emission; besides, Taiwan Patent No.00420723 discloses a method using Plasma Enhanced Chemical Vapor Deposition (PECVD) to form a diamond-like carbon film. In view of the above inventions, it is known that a majority of the prior art diamond-like structres is prepared in films, but so far there is no diamond-like carbon structure disclosed having a high aspect ratio.

Therefore, a method for manufacturing diamond-like carbon films is needed. The diamond-like carbon films have not only structures of high aspect ratio, but also low electron affinity, making them great materials for electron emission.

### SUMMARY OF THE INVENTION

The object of the present invention is to provide a method for manufacturing diamond-like carbon films, the steps comprising: (a) fixing a substrate in a reaction chamber; (b) pumping the pressure of the reaction chamber below 10⁻⁶ torr; (c) introducing at least a carbon-containing gas into the reaction chamber; and (d) depositing a diamond-like carbon film on the substrate by sputtering a graphite target. The deposited DLC film is in a shape of flakes. The flake-shaped structure of the diamond-like film is arranged on the surface of the substrate in a rose-like shape.

Furthermore the lateral height of the flake-shaped structure in the present invention can be in a micrometer-scale, preferably 0.5 *µ*m to 5.0 *µm,* more preferably 0.9 *µ* m to 2.0 *µ* m. The thickness of the flake-shaped structure in the present invention can be in a nanometer-scale, preferably 0.005 *µ*m to 0.1*µ*m, more preferably 0.005 *µ*m to 0.05*µ*m.

Therefore, the diamond-like carbon films prepared by the method of the present invention have a high aspect ratio and low electron affinity, so they are good electron emission sources. In addition, RF sputtering is employed in the present invention to deposit diamond-like carbon film, making large-area processes possible and costs and time of manufacture are reduced.

The introduced gases introduced in step (c) can selectively comprise hydrogen, inert gas, or the combination thereof, wherein the inert gases can be any kind used in sputtering, preferably argon and nitrogen, to provide a reaction environment of ionized gas. Moreover, the introduced carbon-containing gas can be any kind, preferably a hydrocarbon gas, such as methane, acetylene etc., which serves as the carbon source of the diamond-like carbon film.

There is no particular limitation to the flow of the aforementioned gases, and the amount and concentration of the introduced gas into the reaction chamber is adjustable depending on process requirements and the desired structure of the diamond-like carbon film. From the result of the examples of the present invention, the higher concentration of hydrogen in the introduced gas, the looser flake-shaped structure is formed, and the lower density is resulted. On the contrary, the lower concentration of hydrogen in the introduced gas, the denser flake-shaped structure is formed, and the higher density is resulted. In the method of the present invention, the gas used in manufacture of diamond-like carbon film having a flake-shaped structure is preferably a mixture of an inert gas, a carbon-containing gas, and hydrogen. Preferably, the ratio of inert gas : carbon-containing gas : hydrogen is 5-20: 1-10: 0-10, more preferably 8-16: 4-8 : 2-8 °

Before sputtering in step (d) of the method of the present invention, it is preferable to heat the substrate to 350°C to 600°C for depositing a diamond-like carbon film on the surface of the substrate. Of course, there is no particular limitation to the temperature of heating, but they are preferably 350°C to 600°C, more preferably 400°C to 500°C. Moreover, there is no particular limitation to power in the sputtering process, but it is preferably lower than 200 watts, and more preferably lower than 150 watts. Further, prior to introduction of gas into the reaction chamber and sputtering, the pressure of the reaction chamber should be pumped below 10⁻⁵ torr, more preferably below 10⁻⁶torr, and yet more preferably 1×10⁻³ to 20×10⁻³ torr during sputtering.

In the method of the present invention, a diamond-like carbon film having a flake-shaped structure can be formed directly on the surface of the substrate by low-power and low-temperature sputtering, wherein the flake-shaped structure can be arranged on the surface of the substrate in a rose-like pattern, and have a high aspect ratio. The process parameters of sputtering, such as temperature, pressure of the reaction environment during sputtering, and power, can be adjusted depending on the demands of the process.

The method for manufacturing diamond-like carbon films of the present invention proceeds mainly by introducing carbon-containing gas, vaporizing carbon atoms by plasma, and forming a diamond-like carbon film having a flake-shaped structure on the heated substrate.

There is no particular limitation to the flake-shaped structure of the diamond-like carbon film, but it is preferably in a shape of strips or curved strips. The main feature of the flake-shaped structure is its high aspect ratio. Thus, the diamond-like carbon film prepared by the method of the present invention has significant field emission enhancing factors, making it a superior cold-cathode electron-emitting source.

There is no particular limitation to the material of the substrate, but it is preferably semiconductor or glass. To broaden the applications of the diamond-like carbon film prepared by the method of the present invention, the surface of the substrate of the present invention can selectively comprise an additional conductive layer, wherein the conductive layer is between the substrate and the diamond-like carbon film. The material of the conductive layer can be any conventional one, but it is preferably tin oxide, zinc oxide, tin zinc oxide, metal or alloy

In a preferable embodiment, the substrate used in the present invention is glass, wherein the surface of the glass substrate is coated with a conductive layer, such that the diamond-like carbon film having a flake-shaped structure is formed on the surface of the conductive layer. Consequently, a potential can be applied through the conductive layer to the diamond-like carbon film having a flake-shaped structure, allowing the diamond-like carbon film prepared in the present invention to be utilized in electron emission.

In another preferred embodiment, the material of the substrate is semiconductor; because the material is conductive itself, the diamond-like carbon film having a flake-shaped structure is directly formed on the substrate surface and serves as a source of electron emission.

Comparing to carbon nanotubes known in the art, the temperature in process of the diamond-like carbon having micrometer structure in the present invention is lower, and it is possible to grow it directly on the substrate surface, so that the process is facilitated. Besides, the flake-shaped structure of the diamond-like carbon in the present invention has a high aspect ratio, so it has high field emission enhancing factors, and can be applied to various fields of electron emission, for example, cold-cathode emission sources such as field emission components, field emission displays, or planar light sources.

Other objects, advantages, and novel features of the invention will become more apparent from the following detailed description when taken in conjunction with the accompanying drawings.

### BRIEF DESCRIPTION OF THE DRAWINGS

Fig. 1 is a schematic expression of the sputtering reaction chamber 100 for preparing the diamond-like carbon film in a preferred embodiment of the present invention;
Fig. 2a is an SEM photo showing the front surface of the substrate having a diamond-like carbon film on the surface in the preferred embodiment;
Fig. 2b is an SEM photo of the lateral side of the substrate having a diamond-like carbon film on the surface in this preferred embodiment;
Fig. 2c is an SEM photo of the diamond-like carbon film manufactured in this example, which was scraped off and put on the front surface of the substrate; and
Fig. 3 is the Raman spectrum of the diamond-like carbon film prepared in Examples 2 to 6.

### DETAILED DESCRIPTION OF THE PREFERRED EMBODIMENT

### Example 1

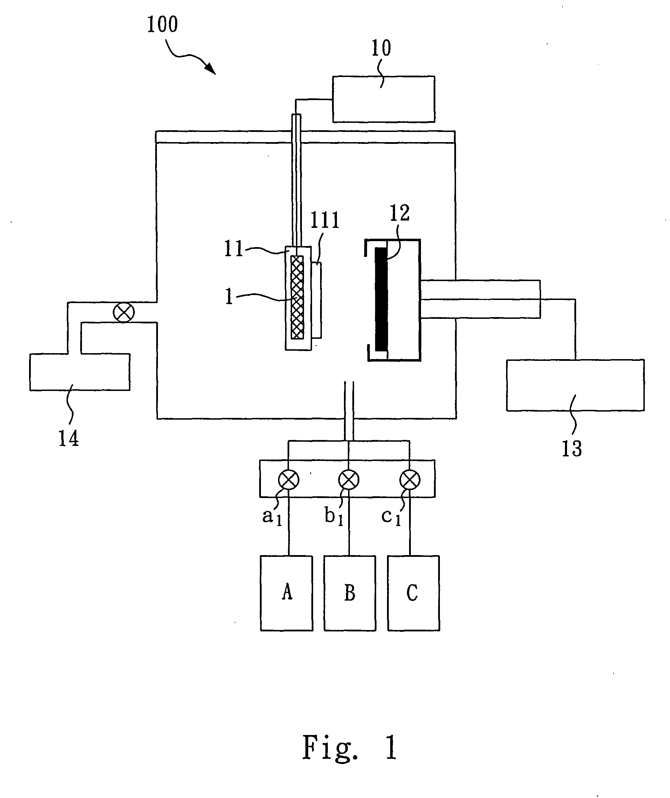

The method for manufacturing a diamond-like carbon film in a preferred embodiment of the present invention is illustrated as following. Fig. 1 is a schematic expression of the sputtering reaction chamber 100 for preparing the diamond-like carbon film in this example.

First a reaction chamber 100 for reaction was provided, which comprised a heater for heating substrate 1, a stage 11 for loading substrate 1, a power source 13 for applying voltage to target 12, and a plurality of gas-supplying elements A, B, and C for providing gas. Note that during manufacture of the diamond-like carbon film, the gas-supplying elements can be added or removed depending on the gas conditions required in the process, and are not limited to the setup described in this example.

Subsequently, the surface of the substrate was cleaned, and the substrate 1 was loaded on the stage 100 in the reaction chamber 11 to be fixed. Substrate 1 in this example is a silicon wafer made of a semiconductor. Pressure of reaction chamber 100 was pumped to below 1 × 10⁻⁵ torr, and substrate 1 was heated with a heater 10 to 400°C.

Then gases were provided by the gas-supplying elements A, B, and C, and the gas flow into the reaction chamber 100 was controlled by a mass flow controller (not shown). Gas-supplying elements A, B, and C in this example are sources of argon, methane, and hydrogen, respectively. Plus, whether the three gases were introduced into the reaction chamber 100 was controlled by gas-supplying al, b1, and cl, in accordance with process conditions. In the example, gases introduced into the reaction chamber 100 include argon, methane, and hydrogen, with a ratio of 2:1:1.

In this example, when the reaction gases were introduced into reaction chamber 100, the pressure of the reaction was controlled around 9×10⁻³ torr. Of course, the pressure in the environment in which sputtering takes place is not restricted to that described in this example, and is adjustable depending on the requirements of the process.

Then pre-sputtering was performed on the graphite target 12 for 30 minutes with 200W RF power, so that contaminants possibly existing on the surface of the graphite target 12 were cleared. Subsequently, shield 111 was opened, and the surface of substrate 1 was sputtered for 70 minutes to form a diamond-like carbon film on the surface of substrate 1.

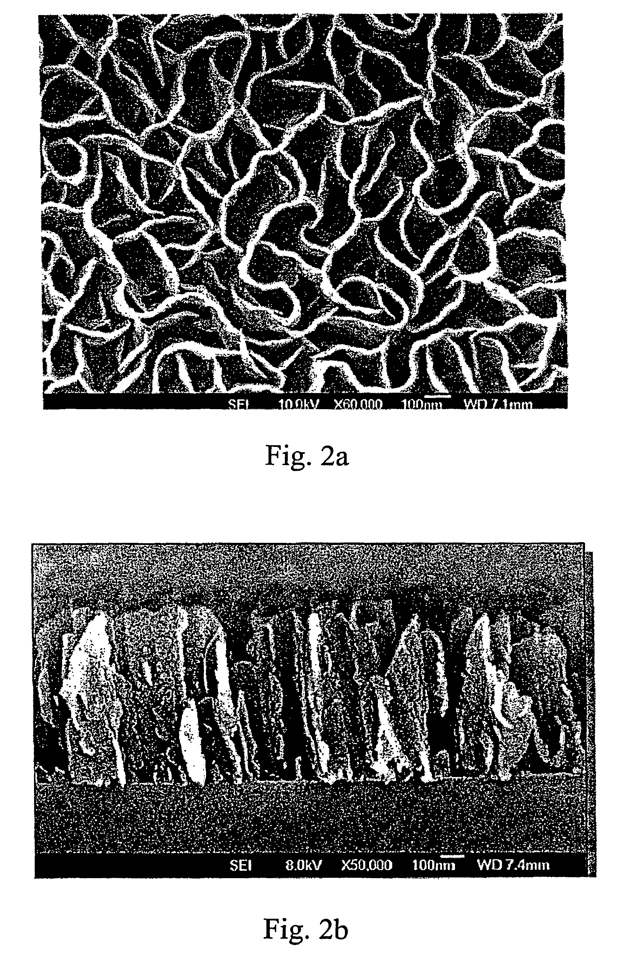

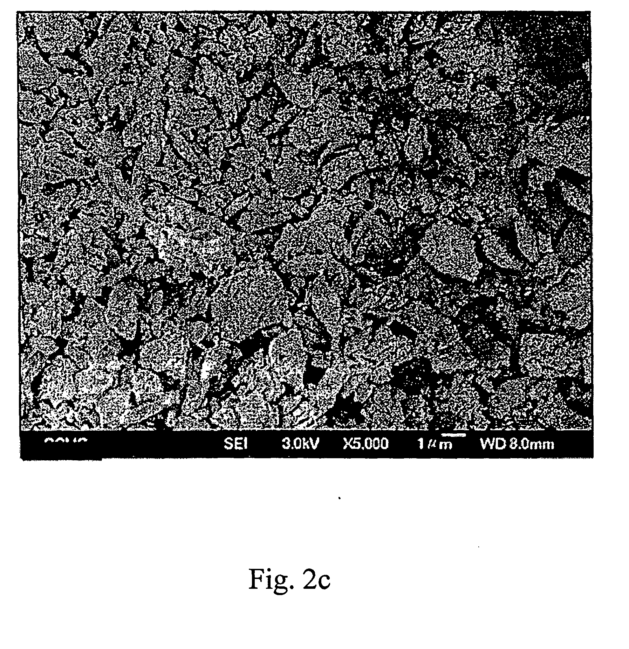

Referring to Fig. 2a, 2b, and 2c, Fig. 2a is an SEM photo showing the front surface of the substrate having a diamond-like carbon film on the surface in the preferred embodiment. Fig. 2b is an SEM photo of the lateral side of the substrate having a diamond-like carbon film on the surface in this preferred embodiment. Fig. 2c is an SEM photo of the diamond-like carbon film manufactured in this example, which was scraped off and put on the front surface of the substrate.

As shown in Fig. 2a and 2b, the diamond-like carbon film prepared in this example was in a curved-strip shape or a long-strip shape, and the flake-shaped structure was arranged on the surface of substrate 1 in a 3-D rose-like pattern, wherein the average height of the flake-shaped structure was 1µm and the average thickness of each flake was 10nm to 20nm, such that the structure having a "high aspect ration" emphasized in the present invention was formed. Referring to Fig. 2c, when the formed diamond-like carbon film was scraped and positioned on the substrate, the average thickness was 10nm to 20nm, and the width was 1-3 µm.

Therefore, the diamond-like carbon film prepared in this example has a high aspect ratio, and the substrate was made of a conductive semiconductor material, the film can be directly applied in electron emission.

### Examples 2 to 6

Examples 2 to 6 proceeded with manufacture of the diamond-like carbon film in the same manner as Example 1, except that the gas conditions were different from those of Example 1, and other process parameters and procedures were similar to Example 1. Hydrogen introduced at various proportions was employed to control the density of the flake-shaped structure of the diamond-like carbon film.

The proportions of gases in Examples 2-6 are listed in Table 1.

**Table 1**

| | Argon | Methane | Hydrogen |
|---|---|---|---|
| Example 2 | 8 | 8 | 8 |
| Example 3 | 10 | 5 | 5 |
| Example 4 | 10 | 5 | 2 |
| Example 5 | 16 | 8 | 0 |
| Example 6 | 16 | 4 | 0 |

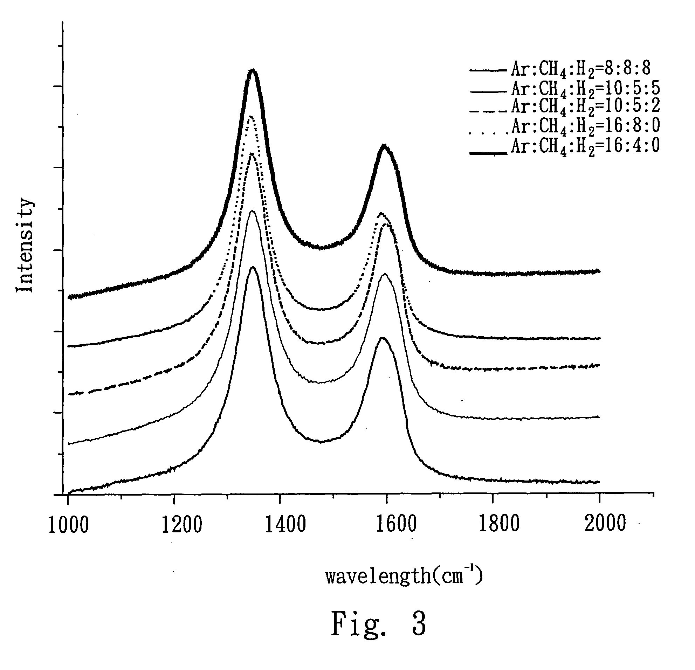

Fig. 3 is the Raman spectrum of the diamond-like carbon film prepared in Examples 2 to 6. Referring to Fig. 3, the diamond-like carbon film prepared in the present invention was composed of SP³ 3-D structure and SP² planar structure, and consequently had a 1332cm⁻¹ absorption peak of a tetrahedral diamond structure, and a 1580cm⁻¹ absorption peak of a planar graphite structure.

In sum, a diamond-like carbon film having a flake-shaped structure in a micrometer scale can be prepared by the method of the present invention. Due to the high aspect ratio of the micrometer-scale flake-shaped structure, the film can serve as an especially suitable material for electron emission, and can be applied to cold-cathode emission sources such as field emission components, field emission displays or planar light sources.

Although the present invention has been explained in relation to its preferred embodiment, it is to be understood that many other possible modifications and variations can be made without departing from the scope of the invention as hereinafter claimed.

## Claims

1. A method for manufacturing diamond-like carbon films, the steps comprising:
(a) fixing a substrate in a reaction chamber;
(b) pumping the pressure of the reaction chamber below 10-6 torr;
(c) introducing at least a carbon-containing gas into the reaction chamber; and
(d) depositing a diamond-like carbon film on the substrate by sputtering a graphite target,
wherein the deposited DLC film is in a shape of flakes, and the flake-shaped structure of the diamond-like film is arranged on the surface of the substrate in a rose-like shape.

2. The method of claim 1, wherein the introduced gases introduced in step (c) further comprise hydrogen, inert gases, or the combination thereof.

3. The method of claim 2, wherein the ratio of inert gas :
carbon-containing gas: hydrogen is 5-20 : 1-10 : 0-10.

4. The method of claim 1, wherein the introduced carbon-containing gas is a hydrocarbon gas.

5. The method of claim 4, wherein the hydrocarbon gas is methane or acetylene.

6. The method of claim 2, wherein the inert gas is argon gas.

7. The method of claim 1, further comprising heating the substrate to 350°C- 600°C before sputtering in step (d).

8. The method of claim 1, further comprising heating the substrate to 400°C- 550°C before sputtering in step (d).

9. The method of claim 1, wherein the material of the substrate is semiconductor or glass.

10. The method of claim 1, wherein the lateral height of the flake-shaped structure is 0.5 µm~5.0µm.

11. The method of claim 1, wherein the lateral height of the flake-shaped structure is 0.9µm~2.0µm.

12. The method of claim 1, wherein the thickness of the flake-shaped structure is 0.005µm to 0.1µm.

13. The method of claim 1, wherein the thickness of the flake-shaped structure is 0.005µm to 0.05µm.

14. The method of claim 1, wherein the flake-shaped structure is in a curved-strip shape or a long-strip shape.

15. The method of claim 1, wherein the surface of the substrate further comprises a conductive layer which is sandwiched between the substrate and the diamond-like film.

16. The method of claim 1, wherein the material of the conductive layer is tin oxide, zinc oxide, tin zinc oxide, metal or alloy.

17. The method of claim 1, wherein power in the sputtering of step (b) process is lower than 200 watts.

18. The method of claim 1, wherein power in the sputtering of step (b) process is lower than 150 watts.

19. The method of claim 1, wherein the pressure of the reaction chamber is 1×10⁻³~20×10⁻³ torr during sputtering.
